# EUROPEAN PATENT APPLICATION

(11) **EP 3 210 712 A1**
(43) Date of publication of application: **30.08.2017**
(21) Application number: 15851494.3
(22) Date of filing: 13.10.2015
(51) Int. Cl.: B23K 26/00, H01S 5/0683

(54) **DIRECT DIODE LASER PROCESSING DEVICE AND OUTPUT MONITORING METHOD FOR SAME**

(30) Priority: 14.10.2014 JP 2014209913
(71) Applicant: Amada Holdings Company Ltd., Kanagawa 259-1196 (JP); Lumentum Operations LLC, Milpitas, California 95035 (US)
(72) Inventor: OGATA, Minoru, Isehara-shi Kanagawa 259-1196 (JP)
(74) Representative: Grünecker Patent- und Rechtsanwälte PartG mbB
(86) International application number: PCT/JP2015/078861
(87) International publication number: WO 2016/060095

(57) **Abstract**

A direct diode laser processing apparatus includes a laser oscillator (11) including a plurality of laser diodes and emitting a multiple-wavelength laser beam, a transmission fiber (12) transmitting the multiple-wavelength laser beam emitted from the laser oscillator (11), a laser processing machine (13) collecting the multiple-wavelength laser beam transmitted through the transmission fiber and processes a workpiece (W), a detecting mechanism (7) sampling part of the multiple-wavelength laser beam and detecting wavelength-by-wavelength light intensities of the sampled laser beam, a monitoring unit (73) monitoring an output decrease in the multiple-wavelength laser beam according to a change in the wavelength-by-wavelength light intensities, and a control module controlling outputs of the plurality of laser diodes according to a monitored result from the monitoring unit. The apparatus properly monitors an output decrease in the multiple-wavelength laser beam.

## Description

### TECHNICAL FIELD

The present invention relates to a direct diode laser processing apparatus and an output monitoring method thereof.

### BACKGROUND ART

Known laser processing apparatuses for processing sheet metal employ, as a laser beam source, a carbon dioxide (CO₂) gas laser oscillator, a YAG laser oscillator, or a fiber laser oscillator. The fiber laser oscillator is superior in beam quality to the YAG laser oscillator and has advantages of providing a very high oscillation efficiency and the like. Due to this, the fiber laser processing apparatus using the fiber laser oscillator is used in industrial fields, in particular, in sheet metal processing (cutting, welding, and the like).

Developed in recent years is a direct diode laser (DDL) processing apparatus that uses, as a laser beam source, a direct diode laser oscillator. The DDL processing apparatus employs a plurality of laser diodes (LDs), superimposes laser beams into a multiple-wavelength laser beam, and transmits the laser beam through a transmission fiber to a processing head. The laser beam emitted from an end face of the transmission fiber is concentrated through and irradiated from collimating and condensing lenses onto a workpiece.

As exemplified in Published PCT International Application No. WO93/16512 (Patent Literature 1), there is a known method of monitoring the output and the like of a laser diode with the use of a photodiode and managing the failure and life of the laser diode.

As exemplified in Japanese Unexamined Patent Application Publication No. 2000-081370 (Patent Literature 2), there is a known apparatus that uses a polarization splitting element to polarize a multiple-wavelength laser beam transmitted through an optical fiber and light receiving elements to respectively receive the polarized components and measures a change in wavelength according to a light intensity ratio among the polarized components.

### SUMMARY OF INVENTION

### Problems to be Solved by Invention

The Patent Literature 1, however, individually monitors output of a laser diode and is unable to monitor output of a multiple-wavelength laser beam used in the DDL processing apparatus. The Patent Literature 2 measures a change in wavelength according to a change in a light intensity ratio among polarized components. Output of the multiple-wavelength laser beam used in the DDL processing apparatus varies wavelength by wavelength, or wavelength band by wavelength band, and therefore, the technique of the Patent Literature 2 is inapplicable to the DDL processing apparatus.

In consideration of the above-mentioned problems, the present invention provides a direct diode laser processing apparatus for processing a workpiece with a multiple-wavelength laser beam, capable of properly monitoring an output decrease in the multiple-wavelength laser beam. Also provided is an output monitoring method for the apparatus.

### Means to Solve Problems

According to an aspect of the present invention, the direct diode laser processing apparatus includes a laser oscillator that has a plurality of laser diodes to emit a multiple-wavelength laser beam, a transmission fiber that transmits the multiple-wavelength laser beam emitted from the laser oscillator, a laser processing machine that condenses the multiple-wavelength laser beam transmitted through the transmission fiber and processes a workpiece, a detecting mechanism that samples part of the multiple-wavelength laser beam and detects wavelength-by-wavelength light intensities of the sampled laser beam, a monitoring unit that monitors, according to a change in the wavelength-by-wavelength light intensities of the multiple-wavelength laser beam, an output decrease in the multiple-wavelength laser beam, and a control module that controls, according to a monitored result from the monitoring unit, outputs of the plurality of laser diodes. The output monitoring method is for the direct diode laser processing apparatus.

### BRIEF DESCRIPTION OF DRAWINGS

Figure 1 is a perspective view illustrating an example of a DDL processing apparatus according to an embodiment of the present invention.
Figure 2(a) is a front view illustrating an example of a laser oscillator according to the embodiment of the present invention and Fig. 2(b) is a side view illustrating the example of the laser oscillator according to the embodiment of the present invention.
Figure 3 is a schematic view illustrating an example of a DDL module according to the embodiment of the present invention.
Figure 4 is a schematic view illustrating examples of a detecting mechanism, a monitoring unit, and the vicinities thereof according to the embodiment of the present invention.
Figure 5 (a) is a graph illustrating an example of a wavelength profile in a normal state, Fig. 5(b) is a graph illustrating an example of a generated wavelength profile, and Fig. 5(c) is a graph illustrating another example of a generated wavelength profile.
Figure 6 is a flowchart explaining an example of an output monitoring method for the DDL processing apparatus according to the embodiment of the present invention.

### MODE OF IMPLEMENTING INVENTION

With reference to the drawings, an embodiment of the present invention will be explained. In the following description of the drawings, the same or like parts are represented with the same or like reference marks.

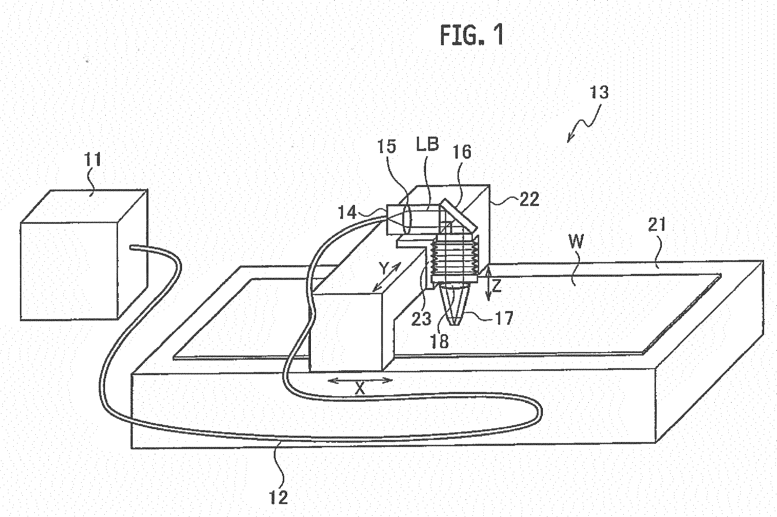

With reference to Fig. 1, a general configuration of a direct diode laser (hereinafter referred to as "DDL") processing apparatus according to the embodiment of the present invention will be explained. The DDL processing apparatus according to the embodiment of the present invention includes, as illustrated in Fig. 1, a laser oscillator 11 that emits a multiple-wavelength laser beam LB, a transmission fiber (process fiber) 12 that transmits the laser beam LB emitted from the laser oscillator 11, and a laser processing machine 13 that condenses the laser beam LB transmitted through the transmission fiber 12 into one having a high-energy concentration and emits the same toward a workpiece (work) W.

The laser processing machine 13 includes a collimator unit 14 that converts, through a collimator lens 15, the laser beam LB emitted from the transmission fiber 12 into a substantial parallel beam, a bend mirror 16 that reflects the laser beam LB converted into the substantial parallel beam in a downward Z-axis direction orthogonal to X- and Y-axis directions, and a processing head 17 that condenses, through a condensing lens 18, the laser beam LB reflected by the bend mirror 16. Employable as the collimator lens 15 and condensing lens 18 are standard lenses such as fused silica plano-convex lenses.

Although not illustrated in Fig. 1, the collimator unit 14 incorporates a lens driving unit that drives the collimator lens 15 in a direction (X-axis direction) parallel to an optical axis. To control the lens driving unit, the DDL processing apparatus further includes a control unit.

The laser processing machine 13 also includes a processing table 21 on which the workpiece W is placed, a portal X-axis carriage 22 that moves in the X-axis direction on the processing table 21, and a Y-axis carriage 23 that moves on the X-axis carriage 22 in the Y-axis direction orthogonal to the X-axis direction. The collimator lens 15 in the collimator unit 14, the bend mirror 16, and the condensing lens 18 in the processing head 17 are preliminarily adjusted to the optical axis, are fixed to the Y-axis carriage 23, and are moved together with the Y-axis carriage 23 in the Y-axis direction. It is possible to arrange a Z-axis carriage movable in an up-down direction with respect to the Y-axis carriage 23 and set the condensing lens 18 on the Z-axis carriage.

The DDL processing apparatus according to the embodiment irradiates the workpiece W with the laser beam LB that has been condensed through the condensing lens 18 to have a smallest condensed diameter, i.e. minimum condensed diameter. While coaxially jetting an assist gas to remove meltage, the DDL processing apparatus moves the X-axis carriage 22 and Y-axis carriage 23. With this, the DDL processing apparatus cuts and processes the workpiece W. The workpiece W may be made from various materials such as stainless steel, mild steel, and aluminum. The thickness of the workpiece W may be, for example, about 0.1 mm to 100 mm. According to the embodiment, the thickness of the workpiece W is preferably 15 mm or greater. It may be 2 mm or greater, or may be 30 mm. It is preferable that the thickness is 100 mm or thinner.

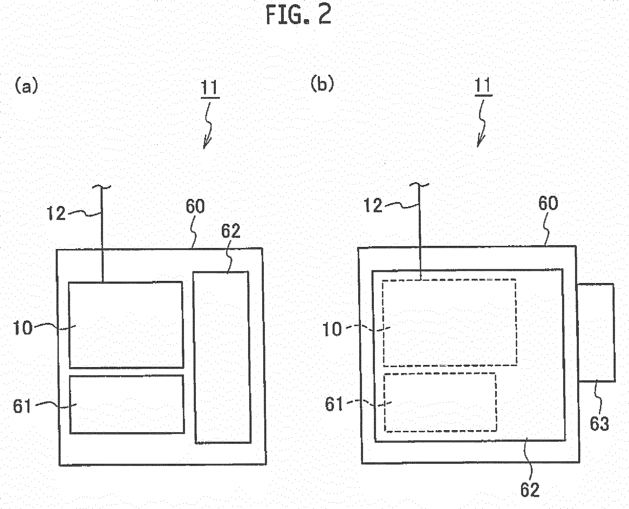

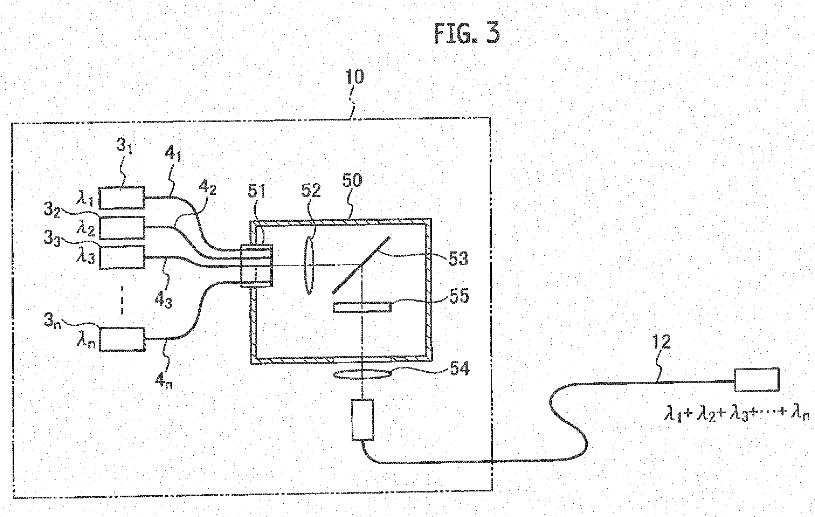

With reference to Figs. 2 and 3, the laser oscillator 11 will be explained. The laser oscillator 11 includes, as illustrated in Figs. 2 (a) and 2(b), a casing 60, a DDL module 10 accommodated in the casing 60 and connected to the transmission fiber 12, a power source unit 61 accommodated in the casing 60 and supplying power to the DDL module 10, a control module 62 accommodated in the casing 60 and controlling outputs of the DDL module 10 and others, and the like. Arranged outside the casing 60 is an air conditioning device 63 to adjust the temperature and humidity of the inside of the casing 60.

The DDL module 10, as illustrated in Fig. 3, overlaps and outputs a multiple-wavelength laser beam having multiple wavelengths λ1, λ2, λ3, ..., λn (hereinafter referred to as {λi}). The DDL module 10 includes a plurality of laser diodes (hereinafter referred to as "LDs") 3₁, 3₂, 3₃, ..., 3n (n being an integer equal to or greater than 4), a spectral beam combining unit 50 connected through fibers 4₁, 4₂, 4₃, ..., 4n to the LDs 3₁, 3₂, 3₃, ..., 3n and carrying out spectral beam combining on the laser beams of multiple wavelengths {λi}, and a condensing lens 54 that condenses a laser beam from the spectral beam combining unit 50 and makes the collected beam incident to the transmission fiber 12.

Adoptable as the plurality of LDs 3₁, 3₂, 3₃, ..., 3n (hereinafter referred to as the plurality of LDs 3) are various kinds of semiconductor lasers. Combinations of kind and number for the plurality of LDs 3 are not particularly limited and are properly selected according to a sheet metal processing purpose. The wavelengths λ1, λ2, λ3, ..., λn of the plurality of LDs 3 are selectable from the ranges of, for example, smaller than 1000 nm, 800 nm to 990 nm, and 910 nm to 950 nm.

The laser beams of multiple wavelengths {λi} are managed and controlled block by block based on, for example, wavelength bands. Outputs of the laser beams are variably and individually adjusted depending on the wavelength bands thereof. Outputs of all wavelength bands are adjustable in such a way as to maintain a constant absorptance.

A cutting process is achieved by simultaneously driving the plurality of LDs and by jetting a proper assist gas such as an oxygen or nitrogen gas to the vicinities of focusing positions. With this, the laser beams with different wavelengths from the plurality of LDs cooperate with one another and with the assist gas such as an oxygen gas to melt the workpiece at high speed. Meltage is blown by the assist gas and the workpiece is speedily cut.

The spectral beam combining unit 50 includes a fixing unit 51 that binds and fixes emitting ends of the fibers 4₁, 4₂, 4₃, ..., 4ₙ to form a fiber array 4, a collimator lens 52 that makes the laser beams from the fibers 4₁, 4₂, 4₃, ..., 4n parallel to one another, a diffraction grating 53 that diffracts the laser beams of multiple wavelengths {λi} to make optical axes thereof coincide with one another, and a partial reflection coupler 55 that constitutes a resonator together with a reflection face arranged at rear ends of the plurality of LDs 3. The arranging position of the partial reflection coupler 55 illustrated in Fig. 3 is an example and is not particularly limited thereto.

When carrying out a cutting process or the like with such a DDL processing apparatus using the multiple-wavelength laser beam, the wavelengths {λi} of the laser beam have their respective beam waists of, for example, about 100 micrometers to 400 micrometers. These plural diameters form multiple focal points. The beam waists are formed by optical elements including the condensing lens 18 having an incident diameter of about 2 mm to 20 mm and a focal length of 50 mm to 300 mm. Output of the laser oscillator 11 is variably controllable and adjustable wavelength by wavelength or wavelength band by wavelength band so that, at an incident angle of 0 to 40 degrees where an incident angle of 0 degrees is normal to a cut face of the workpiece W, an output from a wavelength band on a shorter wavelength side becomes higher than that from a wavelength band on a longer wavelength side. A cutting speed of the workpiece W is selectable in the range of, for example, 60 m/min to 250 m/min.

In the DDL processing apparatus, deterioration (expiration of life) or failure of the plurality of LDs 3 or a misalignment of the optical elements in the spectral beam combining unit 50 may be a main cause of an output decrease of the multiple-wavelength laser beam.

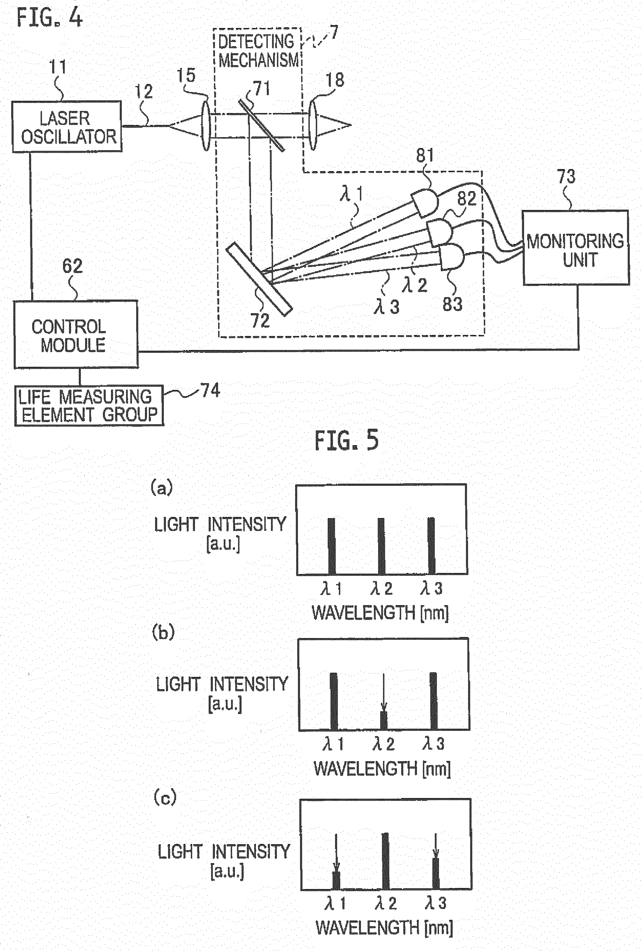

To monitor output of the multiple-wavelength laser beam, the DDL processing apparatus according to the embodiment further includes, as illustrated in Fig. 4, a detecting mechanism 7 and a monitoring unit 73 connected to the detecting mechanism 7. The detecting mechanism 7 separates/samples part of the laser beam having the multiple wavelengths λ1, λ2, and λ3 and detects wavelength-by-wavelength light intensities of the sampled laser beam (λ1, λ2, and λ3). Although the explanation here is made on the bases of the three wavelengths λ1, λ2, and λ3, the number of wavelengths is not limited to three.

The detecting mechanism 7 is arranged between the collimator lens 15 and the condensing lens 18 and includes a splitting element 71 that separates the partial laser beam with wavelengths λ1, λ2, and λ3 passed through the collimator lens 15, a spectroscopic element 72 that disperses the separated laser beam according to the wavelengths λ1, λ2, and λ3, and detecting element groups 81, 82, and 83 that detect the dispersed laser beams of wavelengths λ1, λ2, and λ3, respectively. Transmission of the beams from the splitting element 71 to the detecting element groups 81, 82, and 83 is carried out through a space or fibers.

Adoptable as the splitting element 71 is, for example, a beam splitter, a clad light stripper, or a like optical element. Adoptable as the spectroscopic element 72 is a diffraction grating, a prism, or a like optical element. The detecting element groups 81, 82, and 83 may be a single optical detector, a plurality of optical detectors, or a measuring device, capable of individually detecting, with a sufficient scope and resolution for carrying out an objective control operation, the dispersed beams within wavelength bands that respectively cover the wavelengths λ1, λ2, and λ3. For example, if the spectral beam combining unit 50 involves a misalignment, a wavelength other than the wavelengths λ1, λ2, and λ3 may vary. To deal with this, detecting elements capable of measuring wavelengths other than the wavelengths λ1, λ2, and λ3 may be arranged in addition to the detecting element groups 81, 82, and 83. Instead of separately arranging the spectroscopic element 72 and detecting element groups 81, 82, and 83, an optical spectrum analyzer or the like integrating and incorporating the spectroscopic element 72 and detecting element groups 81, 82, and 83 is employable.

The monitoring unit 73 is a controller constituted with a central processing unit (CPU) or the like. According to detected results from the detecting element groups 81, 82, and 83, the monitoring unit 73 monitors output decreases of many laser beams. As illustrated in Fig. 5(a), the monitoring unit 73 stores in advance in a memory or the like a normal-state intensity distribution (hereinafter referred to also as "wavelength profile") of the wavelengths λ1, λ2, and λ3. According to detected results from the detecting element groups 81, 82, and 83, the monitoring unit 73 evaluates a wavelength profile such as one illustrated in Fig. 5(b). In Fig. 5(b), an intensity of the wavelength λ2 is lower than that in the normal state. This is assumed to be caused by deterioration or failure of an LD corresponding to the wavelength λ2, or a misalignment of the LD corresponding to the wavelength λ2.

The monitoring unit 73 compares the evaluated wavelength profile with the normal-state wavelength profile, and according to a change from the normal-state light intensities of the wavelengths λ1, λ2, and λ3, makes a determination on an output decrease. For example, the evaluated wavelength profile illustrated in Fig. 5(b) shows that an intensity of at least one wavelength, i.e., the intensity of the wavelength λ2 has changed to the outside of a predetermined normal-state range. More precisely, it has decreased by a predetermined threshold or greater. In this case, the monitoring unit 73 determines that an output decrease has occurred. At the same time, the monitoring unit 73 identifies as an abnormal LD the LD corresponding to the wavelength λ2. The predetermined threshold is set within an allowable range based on the normal-state wavelength profile and is stored in advance in a memory or the like of the monitoring unit 73. The monitoring unit 73 sends an alarm and information identifying the abnormal LD to the control module 62.

Receiving the alarm from the monitoring unit 73, the control module 62 is able to entirely stop the apparatus or display the identifying information of the abnormal LD on a display unit. The control module 62 may, according to the identifying information of the abnormal LD from the monitoring unit 73, stop the output of the abnormal LD and increase outputs of other normal LDs to compensate for the output of the abnormal LD. This results in bringing the sum of outputs of the wavelengths of the evaluated wavelength profile close to or equal to the sum of outputs of the wavelengths of the normal-state wavelength profile, thereby continuing the operation of the apparatus.

There will be a case that the monitoring unit 73 generates, as illustrated in Fig. 5(c), a wavelength profile involving intensity decreases in the wavelengths λ1 and λ3. This is assumed to be caused by a misalignment of the wavelength combining unit. If the intensities of the wavelengths λ1 and λ3 change/decrease by the predetermined threshold in the evaluated wavelength profile, the monitoring unit 73 determines that an output decrease has occurred and identifies LDs corresponding to the wavelengths λ1 and λ3 as abnormal LDs.

It is possible that, if the sum of outputs of the wavelengths λ1, λ2, and λ3 in the evaluated wavelength profile decreases below the sum of outputs of the wavelengths λ1, λ2, and λ3 in the normal-state wavelength profile by a predetermined threshold or greater, the monitoring unit 73 determines the occurrence of an output decrease. In this case, the monitoring unit 73 sends an alarm and a comparison result of the wavelength profiles to the control module 62, so that the control module 62 may entirely stop the apparatus or display the comparison result of the wavelength profiles on the display unit.

The control module 62 is also connected to a plurality of life measuring elements as a life measuring element group 74. The life measuring element group 74 is constituted with, for example, a plurality of PIN photodiodes or the like. The elements contained in the life measuring element group 74 are arranged in the vicinities of the LDs 31, 32, 33, ..., 3n illustrated in Fig. 3. The life measuring element group 74 receives laser beams outputted from the LDs 31, 32, 33, ..., 3n, detects light intensities of the laser beams, and measures life (deterioration) or failure of the LDs 31, 32, 33, ..., 3n.

According to a detected result from the life measuring element group 74, the control module 62 stops output of an LD that has expired, deteriorated, or failed and increases outputs of other normal LDs to compensate for the output of the abnormal LD. Alternatively, the control module 62 may, according to the detected result from the life measuring element group 74, increase a control current value for the deteriorated LD close to a rated output.

Also, according to the monitored result from the monitoring unit 73 and the detected result from the life measuring element group 74, the control module 62 may identify/presume a cause of the output decrease of the multiple-wavelength laser beam. More precisely, if the LD specified by the abnormal LD identifying information from the monitoring unit 73 indicates no light intensity decrease, i.e. not detected as failed or deteriorated, according to the detected result from the life measuring element group 74, the control module 62 determines that the cause of the output decrease of the multiple-wavelength laser beam is not failure or deterioration of LDs but is a misalignment in the multiple-wavelength laser beam. This function may be provided for the monitoring unit 73 instead of the control module 62.

With this, the cause of an output decrease in the multiple-wavelength laser beam can be discriminated between failure or deterioration of LDs and a misalignment in the multiple-wavelength laser beam. If it is determined that the cause is a misalignment in the spectral beam combining unit 50, it is possible to avoid taking a countermeasure that is taken when LDs fail or deteriorate, i.e., a current increasing feedback to obtain a rated output. This prevents a fiber loss or fiber burning. Clarifying the cause of an output decrease results in taking a proper countermeasure.

If the cause of an output decrease is a misalignment in the spectral beam combining unit 50, a beam parameter product (BPP) deteriorates. Even if the output decrease is too small to raise a problem for the case employing a laser beam of a single wavelength, the BPP deterioration due to the output decrease may cause processing defects for the case employing a multiple-wavelength laser beam. In addition, if the cause of the output decrease is a misalignment in the spectral beam combining unit 50, the laser beam made incidence to the transmission fiber 12 produces extreme heat to easily burn the fiber. Accordingly, identifying the cause of an output decrease as a misalignment in the spectral beam combining unit 50 enables the apparatus to be stopped at once even if the output decrease is too small to take a countermeasure that must be taken if LDs fail or deteriorate, thereby preventing the burning of the transmission fiber 12.

In some cases, the control module 62 is able to determine (presume) that, according to only a monitored result from the monitoring unit 73, the cause of an output decrease is a misalignment in the spectral beam combining unit 50. More precisely, if the intensities of the wavelengths λ1 and λ3 drastically decrease as illustrated in Fig. 5(c) compared to the normal-state wavelength profile, or if the intensity of a wavelength band that is not oscillated and not expected to change changes, a determination (presumption) will be made that the cause is not the deterioration or failure of LDs but a misalignment in the spectral beam combining unit 50.

### <Output Monitoring Method of Laser Beam>

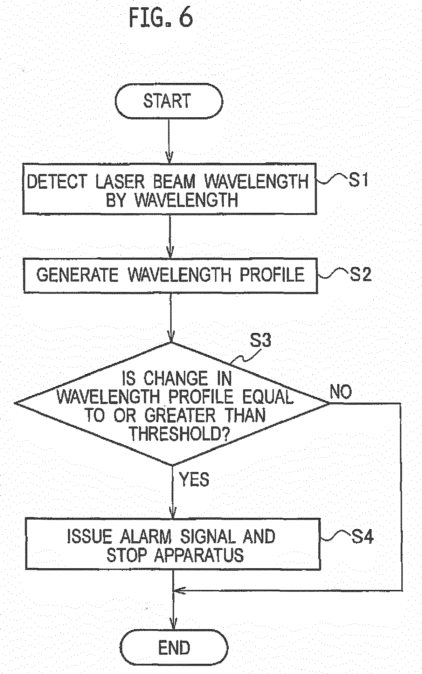

With reference to a flowchart of Fig. 6, an example of an output monitoring method for the DDL processing apparatus according to the embodiment of the present invention will be explained.

In step S1, the detecting mechanism 7 samples part of the multiple-wavelength laser beam emitted from the transmission fiber 12 and detects wavelength-by-wavelength light intensities of the sampled laser beam.

In step S2, the monitoring unit 73 generates, on the basis of the detected result from the detecting mechanism 7, a wavelength profile. In step S3, the wavelength profile generated by the monitoring unit 73 is compared with the normal-state wavelength profile read out of the memory. If a change in the generated wavelength profile compared to the normal-state profile is equal to or greater than the predetermined threshold, it is determined that there is an abnormal LD and step S4 is carried out.

In step S4, the monitoring unit 73 provides the control module 62 with an alarm and information identifying the abnormal LD. The control module 62 receives the alarm and stops the apparatus.

As explained above, the embodiment of the present invention samples part of the multiple-wavelength laser beam, detects wavelength-by-wavelength light intensities of the sampled laser beam, and according to a change in the wavelength-by-wavelength light intensities (a wavelength profile) of the multiple-wavelength laser beam, monitors an output decrease in the multiple-wavelength laser beam. According to the monitored result, the embodiment controls the plurality of laser diodes. Namely, the embodiment properly monitors an output decrease and thereby prevents burning and processing defects caused by BPP increase.

### (Other Embodiments)

Although the present invention has been explained on the basis of embodiment, it should not be understood that the explanation and drawings that form part of the disclosure limit the present invention. The disclosure may clarify, for persons skilled in the art, various substitutes, alternatives, and applications for the present invention.

According to the embodiment of the present invention, the detecting mechanism 7 is installed between the collimator lens 15 and the condensing lens 18, i.e. at the processing head, in the laser processing machine 13 and samples a laser beam emitted from the transmission fiber 12. This does not limit the present invention. For example, it may be installed between the spectral beam combining unit 50 in the laser oscillator 11 illustrated in Fig. 3 and the transmission fiber 12. The detecting mechanism 7 detects a light intensity of an incident laser beam to be made incident to the transmission fiber 12.

In a case where the transmission fiber 12 illustrated in Fig. 1 consists of two segments, i.e., a first transmission fiber connected to the laser oscillator 11 and a second transmission fiber connected between the first transmission fiber and the laser processing machine 13 and where the first and second transmission fibers are connected through optical elements such as beam couplers, the detecting mechanism 7 may be installed at the location where the optical elements are present. The detecting mechanism 7 detects a light intensity of a laser beam emitted from the first fiber.

Sheet metal processing to be carried out by the DDL processing apparatus according to the embodiment of the present invention includes not only cutting but also laser forming, annealing, abrading, and other kinds of sheet metal processing.

In this way, the present invention naturally covers various embodiments and the like that are not explained herein. Accordingly, technical scopes of the present invention are determined only by invention specific matters that are pertinent to the above-mentioned explanation and the claims.

The present invention thus provides the direct diode laser processing apparatus and output monitoring method, capable of properly monitoring an output decrease in a multiple-wavelength laser beam when using the multiple-wavelength laser beam for processing a workpiece.

### (United States Designation)

In connection with United States designation, this international patent application claims the benefit of priority under 35 U.S.C. 119(a) to Japanese Patent Application No. 2014-209913 filed on October 14, 2014 whose disclosed contents are incorporated herein by reference.

## Claims

1. A direct diode laser processing apparatus comprising:
a laser oscillator including a plurality of laser diodes and emitting a multiple-wavelength laser beam;
a transmission fiber transmitting the multiple-wavelength laser beam emitted from the laser oscillator;
a laser processing machine collecting the multiple-wavelength laser beam transmitted through the transmission fiber and processing a workpiece;
a detecting mechanism sampling part of the multiple-wavelength laser beam and detecting wavelength-by-wavelength light intensities of the sampled laser beam;
a monitoring unit monitoring an output decrease in the multiple-wavelength laser beam according to a change in the wavelength-by-wavelength light intensities of the multiple-wavelength laser beam; and
a control module controlling outputs of the plurality of laser diodes according to a monitored result from the monitoring unit,.

2. The direct diode laser processing apparatus according to claim 1, wherein:
the monitoring unit determines that there is an output decrease in the multiple-wavelength laser beam if any one of the wavelength-by-wavelength light intensities of the multiple-wavelength laser beam changes from a normal state by a predetermined threshold or greater and identifies a laser diode corresponding to the wavelength whose light intensity has decreased by the predetermined threshold or greater; and
the control module stops the output of the laser diode identified by the monitoring unit and increases outputs of other normal laser diodes to compensate for the output of the stopped laser diode.

3. The direct diode laser processing apparatus according to claim 1, wherein:
the monitoring unit determines that, if the sum of the wavelength-by-wavelength light intensities of the multiple-wavelength laser beam changes from that of a normal state by a predetermined threshold, there is an output decrease in the multiple-wavelength laser beam; and
the control module stops the apparatus if the monitoring unit determines that there is an output decrease in the multiple-wavelength laser beam.

4. The direct diode laser processing apparatus according to any one of claims 1 to 3, further comprising
a plurality of photodiodes that detect light intensities of laser beams outputted from the plurality of laser diodes, respectively, wherein
the control module identifies and determines a cause of the output decrease in the multiple-wavelength laser beam according to the monitored result from the monitoring unit and the detected results from the plurality of photodiodes.

5. The direct diode laser processing apparatus according to any one of claims 1 to 4, wherein the detecting mechanism includes:
a splitting element that splits part of the multiple-wavelength laser beam;
a spectroscopic element that spectroscopically separates the split laser beam wavelength by wavelength; and
a detecting element group that detects the spectroscopically separated laser beams wavelength by wavelength.

6. The direct diode laser processing apparatus according to any one of claims 1 to 5, wherein
the detecting mechanism is arranged in the laser processing machine and detects light intensities of the multiple-wavelength laser beam emitted from the transmission fiber.

7. The direct diode laser processing apparatus according to any one of claims 1 to 5 wherein:
the transmission fiber includes a first transmission fiber connected to the laser oscillator and a second transmission fiber connected between the first transmission fiber and the laser processing machine; and
the detecting mechanism is arranged between the first and second transmission fibers and detects light intensities of the multiple-wavelength laser beam emitted from the first transmission fiber.

8. The direct diode laser processing apparatus according to any one of claims 1 to 5, wherein
the detecting mechanism is arranged in the laser oscillator and detects light intensities of the multiple-wavelength laser beam to be made incident to the transmission fiber.

9. An output monitoring method for the direct diode processing apparatus according to any one of claims 1 to 8, wherein:
a step of sampling part of the multiple-wavelength laser beam and detecting wavelength-by-wavelength light intensities of the sampled laser beam; and
a step of monitoring, according to a change in the wavelength-by-wavelength light intensities of the multiple-wavelength laser beam, an output decrease in the multiple-wavelength laser beam.
